# FASCICULE DE BREVET EUROPEEN

(11) **EP 2 757 590 B1**
(45) Date de publication et mention de la délivrance du brevet: **11.09.2019**
(21) Numéro de dépôt: 14151442.2
(22) Date de dépôt: 16.01.2014
(51) Int. Cl.: H01L 29/78, H01L 29/66, H01L 29/423, H01L 29/786

(54) **Transistor à grille et à plan de masse couplés**
Transistor mit einer mit der Masseebene gekoppelten Gateelektrode
Transistor with a gate coupeld to the ground plane

(30) Priorité: 16.01.2013 FR 1350381
(43) Date de publication de la demande: 23.07.2014
(73) Titulaire: Commissariat à l'Énergie Atomique et aux Énergies Alternatives, 75015 Paris (FR); STmicroelectronics SA, 92120 Montrouge (FR)
(72) Inventeur: Giraud, Bastien, 38340 Voreppe (FR); Noel, Jean-Philippe, 38330 Montbonnot Saint Martin (FR); Vinet, Maud, 38140 Rives sur Fure (FR)
(74) Mandataire: Guérin, Jean-Philippe

(56) Documents cités:
- US-A1- 2005 003 592
- US-A1- 2006 286 724
- US-A1- 2007 008 013
- US-A1- 2012 299 098
- ORTIZ-CONDE A ET AL: "Multi-gate 3-D SOI MOSFETs as the mainstream technology in high speed CMOS applications", ELECTRON DEVICES FOR MICROWAVE AND OPTOELECTRONIC APPLICATIONS, 2003. EDMO 2003. THE 11TH IEEE INTERNATIONAL SYMPOSIUM ON 17-18 NOV. 2003, PISCATAWAY, NJ, USA,IEEE, 17 novembre 2003 (2003-11-17), pages 115-121, XP010678525, DOI: 10.1109/EDMO.2003.1260004 ISBN: 978-0-7803-7904-6

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (latchup en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour Fully Depleted Silicium On Insulator en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser une grille arrière ou un plan de masse polarisé disposé entre une couche d'oxyde isolante mince (TBOX ou UTBOX) et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT (pour « Low Vt » en langue anglaise, typiquement 400mV), de transistors à haute tension de seuil dits HVT (pour « High Vt » en langue anglaise, typiquement 550mV) et de transistors à tension de seuil moyenne dits SVT (pour « Standard Vt » en langue anglaise, typiquement 450mV).

Différentes conceptions ont été développées afin d'optimiser le contrôle électrostatique du canal de tels transistors (quantifié notamment par les valeurs DIBL (pour drain-induced barrier lowering en langue anglaise) et SS (pour subthreshold swing en langue anglaise).

Selon une première conception intitulée 3DFDSOI, le canal présente une largeur supérieure à son épaisseur (dimension selon la perpendiculaire à la couche d'oxyde isolante) et la grille enveloppe à la fois les faces latérales et la face supérieure du canal.

Selon une deuxième conception connue sous la dénomination 'Tri Gate', le canal présente une largeur sensiblement équivalente à son épaisseur et la grille enveloppe à la fois les faces latérales et la face supérieure du canal. On considère globalement que l'on démultiplie le nombre de grilles agissant sur le canal.

Selon une troisième conception connue sous la dénomination 'FinFET', le canal présente une largeur inférieure à son épaisseur et la grille enveloppe à la fois les faces latérales et la face supérieure du canal.

Le but général de ces conceptions est de maximiser le recouvrement du canal par la grille. Parmi ces conceptions, on considère généralement que plus le rapport entre l'épaisseur et la largeur du canal est élevé :
- plus on obtient un contrôle électrostatique du canal élevé ;
- plus le procédé de fabrication du transistor est complexe ;
- plus le procédé de fabrication du transistor comporte de dispersions sur la largeur de canal et sur la tension de seuil;
- moins la tension de seuil du transistor peut être adaptée par la polarisation de sa grille arrière.

Ainsi, avec une conception du type FinFET, il s'avère particulièrement délicat de réaliser des circuits intégrés comportant des transistors ayant des tensions de seuil différentes ou des tensions de seuil configurables dynamiquement. Il est notamment délicat de compenser les dispersions de la tension de seuil par polarisation de la grille arrière.

Le document US20050003592 décrit un transistor de type Gate All Around.Sur une couche d'isolant enterrée, on réalise une grille arrière en métal. Un isolant est présent sur cette grille arrière pour isoler la grille arrière du canal. La grille est formée jusqu'en contact avec la grille arrière métallique.

Le document US20060286724 décrit une structure de transistor Tri-gate. Le transistor Tri-gate comprend un substrat, un plan de masse au dessus du substrat, une couche d'isolant enterré disposé au dessus du plan de masse, une couche active disposée séparée du plan de masse par l'isolant, le canal dont la partie supérieure et les faces latérales sont couvertes par la grille.

Le document US20120299098 décrit de façon générique une structure FinFet avec grille arrière et un procédé d'obtention de celle-ci.

Le document 'Multi-gate 3D SOI Mosfets as the mainstream technology...' recence de façon succincte différentes solutions destinées à améliorer le contrôle de la grille sur le canal d'un transistor SOI.

L'invention vise à résoudre un ou plusieurs de ces inconvénients. L'invention porte ainsi sur un circuit intégré et sur un procédé de fabrication d'un circuit intégré, tels que définis dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe transversale d'un circuit intégré muni d'un transistor FDSOI selon l'invention, dans la longueur de son canal ;
- les figures 2 et 3 sont des vues en coupe transversale dans la largeur du canal du transistor, pour des première et deuxième variantes d'un premier mode de réalisation de l'invention ;
- les figures 4 et 5 sont des vues en coupe transversale dans la largeur du canal du transistor, pour des troisième et quatrième variantes d'un premier mode de réalisation de l'invention ;
- la figure 6 est une vue en coupe transversale dans la largeur du canal de transistors, pour une déclinaison de la deuxième variante du premier mode de réalisation ;
- la figure 7 est une vue de dessus schématique d'un exemple de porte logique formée dans un circuit intégré selon l'invention ;
- la figure 8 est une vue de dessus illustrant un premier exemple de cointégration de différents transistors ;
- la figure 9 est une vue de dessus illustrant un deuxième exemple de cointégration de différents transistors ;
- la figure 10 est une vue de dessus illustrant un troisième exemple de cointégration de différents transistors ;
- les figures 11 à 21 sont des vues en coupe illustrant différentes étapes d'un exemple de procédé de fabrication d'un circuit intégré selon l'invention ;
- la figure 22 illustre une variante d'un circuit intégré au même stade du procédé de fabrication que la figure 21 ;
- les figures 23 et 24 sont des vues en coupe illustrant des étapes de procédé pour la réalisation d'une configuration telle qu'illustrée à la figure 10.

L'invention propose d'accroître le couplage entre la grille et le canal d'un transistor FDSOI, en recouvrant d'une part une face latérale et une face supérieure du canal par cette grille, et en disposant d'autre part au moins une partie de la grille à une distance d'un plan de masse inférieure à l'épaisseur d'une couche d'isolant enterré séparant ce plan de masse du canal.

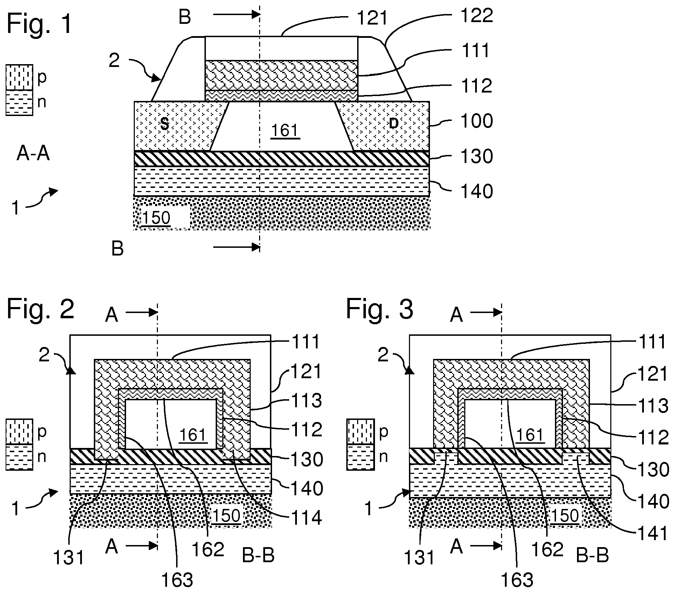

La figure 1 est une vue en coupe transversale d'un circuit intégré 1 muni d'un transistor FDSOI 2 selon l'invention. La section transversale illustrée est ici réalisée dans la longueur du canal 161 du transistor 2.

Le circuit intégré 1 comprend un substrat de silicium 150, présentant un dopage de type P dans cet exemple. Un plan de masse 140 (généralement désigné par les termes 'ground plane', 'back plane' ou 'back gate' en langue anglaise) est ménagé au dessus du substrat 150. Une couche d'isolant électrique enterré 130 sépare le plan de masse 140 du transistor 2. La couche d'isolant enterré 130 est par exemple réalisée en oxyde de silicium. La couche 130 est ainsi surmontée par une couche active de silicium 100 dans laquelle la source S, le canal 161 et le drain D du transistor 2 sont ménagés. Le canal 161 est donc en particulier séparé du plan de masse 140 par la couche d'isolant enterré 130.

Le canal 161 est recouvert par une couche d'oxyde de grille 112. L'oxyde de grille 112 est surmonté par un empilement de grille comprenant une grille métallique 111 et une couche de polysilicium 121. L'empilement de grille 112 est délimité latéralement par des espaceurs 122. Des tranchées d'isolation (non illustrées) sont placées autour du transistor 2 entre la surface de la couche 100 jusqu'au plan de masse 140.

Afin de permettre une modulation de la tension de seuil du transistor 2 en jouant sur la polarisation et le dopage du plan de masse 140, la couche d'isolant enterré 130 est du type UTBOX, ce type de couche présentant typiquement une épaisseur inférieure ou égale à 50 nm, de préférence inférieure ou égale à 20 nm, voire inférieure ou égale à 10 nm.

Le plan de masse 140 permet d'améliorer le contrôle électrostatique du canal du transistor en limitant la pénétration des champs électriques générés par le drain et la source sous le canal 161. La réduction du couplage électrostatique latéral réduit les effets canaux courts et limite l'effet de déplétion par le drain DIBL.

Les dopages suivants peuvent par exemple être utilisés :
N_{GP} (dopage du plan de masse 140)=10¹⁸cm⁻³
N_{S} (dopage de la couche substrat 150)=3*10¹⁵cm⁻³
N_{C} (dopage du canal 161)=3*10¹⁵cm⁻³

Selon l'invention, au moins une partie de la grille 111 est à une distance du plan de masse 140 inférieure à l'épaisseur de la couche d'isolant enterré 130 séparant ce plan de masse 140 du canal 161. Dans les différentes variantes détaillées par la suite, la grille 111 recouvre la face supérieure 162 du canal 161 et comporte au moins une portion latérale 113 recouvrant une face latérale 163 du canal. Cette portion 113 est disposée au dessus du plan de masse 140.

Les figures 2 et 3 sont des vues en coupe transversale schématique de première et deuxième variantes selon un premier mode de réalisation. Les coupes transversales illustrées sont ménagées dans la largeur du canal du transistor 2. Dans les variantes des figures 2 et 3, la grille 111 comporte deux portions latérales 113 s'étendant de part et d'autre du canal 161, pour recouvrir deux faces latérales 163 du canal 161.

Dans ce premier mode de réalisation, le plan de masse 140 est isolé électriquement de la grille 111 par l'intermédiaire de la couche d'isolant enterré 130. L'épaisseur de la couche d'isolant enterré 130 entre le plan de masse 140 et les portions latérales 113 (illustrée par la zone 131) est ici au moins 5 fois inférieure à l'épaisseur de la couche d'isolant enterré 130 entre le canal 161 et le plan de masse 140. Le plan de masse 140 présente alors un excellent couplage électrostatique avec la grille 111 ce qui favorise le contrôle électrostatique du canal 161. L'épaisseur de la couche 130 entre les portions latérales 113 et le plan de masse 140 est avantageusement au moins cinq fois inférieure, voire au moins 10 fois inférieure à l'épaisseur de la couche 130 entre le canal 161 et le plan de masse 140. L'épaisseur de la couche 130 entre les portions latérales 113 et le plan de masse 140 est inférieure ou égale à 3 nm, de préférence inférieure ou égale à 2 nm, et peut même être égale à 1 nm.

Du fait de l'isolation électrique entre la grille 111 et le plan de masse 140 on peut appliquer une polarisation indépendante sur le plan de masse 140, afin de permettre un contrôle de la valeur de la tension de seuil du transistor 2. En outre, le volume de semi-conducteur à polariser lors de l'application d'une tension sur la grille 111 est relativement réduit, ce qui permet donc d'obtenir une commutation plus rapide du transistor 2.

Dans la variante de la figure 2, la portion latérale 113 de la grille 111 s'étend dans l'épaisseur de la couche d'isolant enterré 130. La portion latérale 113 de la grille comporte une saillie 114 qui s'étend à travers la couche d'isolant enterré 130. Les saillies 114 peuvent par exemple être formées par un creusement localisé de la couche 130 avant de déposer le matériau de la grille 111. Dans la variante de la figure 3, le plan de masse 140 s'étend dans l'épaisseur de la couche d'isolant enterré 130. Le plan de masse 140 comporte ainsi des saillies verticales 141 qui s'étendent dans la couche d'isolant enterré 130. Les saillies verticales 141 peuvent par exemple être formées durant des étapes de reprise d'épitaxie du procédé de fabrication.

Bien que le plan de masse 140 présente un dopage de type N dans les exemples des figures 1 à 3, le plan de masse 140 peut bien entendu également présenter un dopage de type P, afin de modifier la valeur de la tension de seuil du transistor 2. Bien que le plan de masse 140 soit ménagé directement sur le substrat 150 dans les exemples des figures 1 à 3, le plan de masse 140 peut bien entendu également être séparé de substrat 150 par l'intermédiaire d'un caisson profondément enterré.

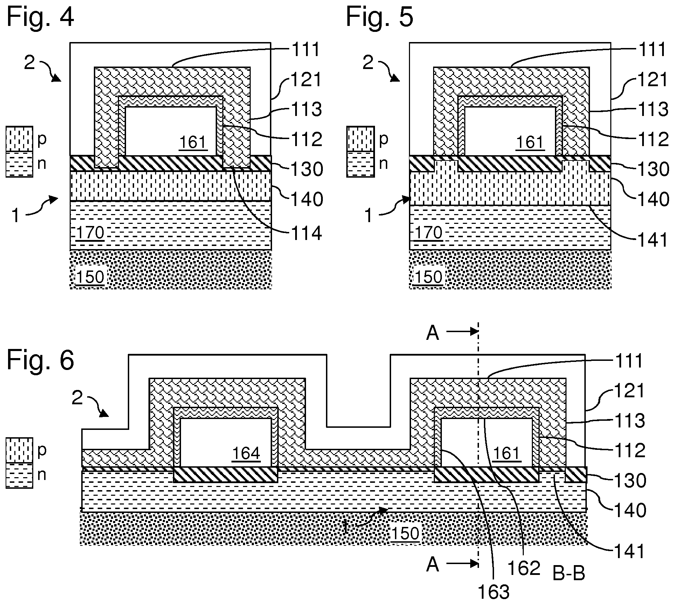

Les figures 4 et 5 sont des vues en coupe transversale schématique de troisième et quatrième variantes du circuit intégré 1 selon le premier mode de réalisation. Les coupes transversales illustrées sont ménagées dans la largeur du canal du transistor 2. Dans les variantes des figures 4 et 5, la grille 111 comporte deux portions latérales 113 s'étendant de part et d'autre du canal 161, pour recouvrir deux faces latérales 163 du canal 161.

Dans ces variantes, le plan de masse 140 comporte un dopage de type P. Dans ces variantes, le plan de masse 140 est séparé du substrat 150 par l'intermédiaire d'un caisson profondément enterré 170, présentant en l'occurrence un dopage de type N.

Dans la variante de la figure 4, la portion latérale 113 de la grille 111 s'étend dans l'épaisseur de la couche d'isolant enterré 130 et comporte une saillie 114 qui s'étend dans la couche d'isolant enterré 130.

Dans la variante de la figure 5, le plan de masse 140 s'étend dans l'épaisseur de la couche d'isolant enterré 130 et comporte ainsi des saillies verticales 141 qui s'étendent dans la couche d'isolant enterré 130.

Afin de favoriser l'influence des portions latérales 113 sur le contrôle électrostatique du canal 161, le rapport entre la largeur du canal 161 et son épaisseur est avantageusement inférieur ou égal à 2,5. Afin de favoriser l'influence du plan de masse 140 sur la tension de seuil du transistor 2 et de faciliter son processus de fabrication, le rapport entre la largeur du canal 161 et son épaisseur est avantageusement au moins égal à 0,75.

Afin de faciliter la fabrication de transistors dont la largeur de grille est supérieure à celle du pas de piste (track pitch en langue anglaise), on peut avantageusement réaliser plusieurs canaux s'étendant entre la source et le drain d'un transistor. Chaque canal présente alors une largeur inférieure au pas de piste, la largeur de canal du transistor étant alors obtenue par le nombre de canaux qu'il comporte. La distance Dc entre deux canaux parallèles pourra par exemple être obtenue par la formule suivante : Dc=2*Epox+Eming, avec Epox l'épaisseur de l'oxyde de grille, et Eming l'épaisseur minimale du métal de grille. Une valeur usuelle pour Epox et Eming est de 3nm. Le pas de piste minimal pour le procédé de réalisation peut être défini comme la somme de la largeur du canal (typiquement comprise entre 10 et 15 nm) et de la distance Dc.

La figure 6 est une vue en coupe transversale d'un transistor 2, correspondant à une déclinaison de la deuxième variante du premier mode de réalisation. Le transistor 2 comporte ici au moins le premier canal 161 et un deuxième canal 164. La grille 111 et ses portions latérales 113 recouvrent ici les faces supérieures et les faces latérales des canaux 161 et 164. Cette déclinaison permet d'adapter la largeur de canal à une valeur souhaitée, avec des dispersions réduites et avec une conception facilitée. Un nombre de canaux parallèles adéquat pourra par exemple être défini pour une largeur de canal donnée.

La formation de la grille 111 peut comprendre une même étape de dépôt métallique pour l'ensemble du circuit intégré 1. De même, la formation de la couche d'oxyde de grille 112 peut être réalisée lors d'une même phase pour l'ensemble du circuit intégré 1.

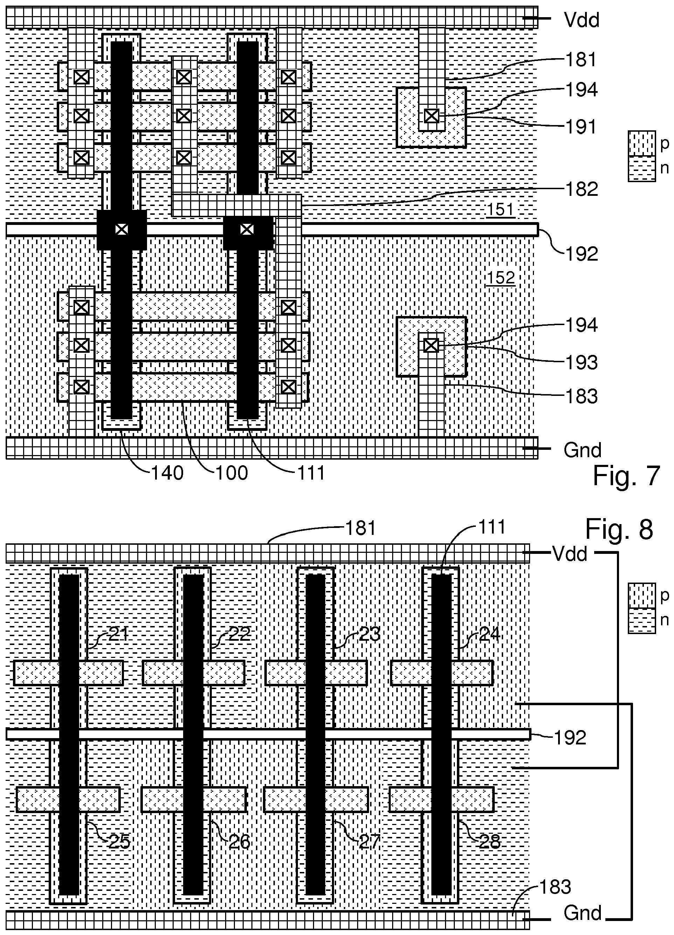

La figure 7 est une vue de dessus d'un exemple de topographie d'une porte NON-ET NAND2 formée dans un exemple de circuit intégré 1 selon l'invention. On distingue deux transistors pMOS dans la partie supérieure et deux transistors nMOS dans la partie inférieure. Les transistors pMOS et les transistors nMOS sont séparés par une tranchée d'isolation profonde 192. Une ligne d'alimentation métallique 181 raccorde les sources des transistors pMOS à une tension Vdd. La ligne d'alimentation métallique 181 polarise également un caisson 151 dopé N par l'intermédiaire d'un plot semi-conducteur 191 et d'un contact 194. Une ligne d'alimentation métallique 183 raccorde la source d'un transistor nMOS à une tension Gnd. La ligne d'alimentation métallique 183 polarise également un caisson 152 dopé P par l'intermédiaire d'un plot semi-conducteur 193 et d'un contact 194. La source de l'autre transistor nMOS est connectée au drain des transistors pMOS par l'intermédiaire d'une connexion métallique 182. Chaque transistor pMOS et chaque transistor nMOS comporte ici trois canaux parallèles pour présenter une largeur de canal adéquate. Une grille commune 111 surplombe les canaux du transistor nMOS et du transistor pMOS de gauche. Une autre grille commune 111 surplombe les canaux du transistor nMOS et du transistor pMOS de droite.

Comme illustré, la gravure de la couche 130 est ici plus large que la grille 111. Cela permet avantageusement de réduire le coût du masque de gravure de la couche 130.

La figure 8 est une vue de dessus illustrant un premier exemple de cointégration de transistors présentant différentes tensions de seuil. Le circuit intégré comprend une rangée de transistors nMOS 21 à 24 et une rangée de transistors pMOS 25 à 28. Les transistors 23, 24, 26 et 27 sont ménagés au dessus de caissons à dopage de type P, et au dessus de plans de masse à dopage de type N. Ces caissons à dopage de type P sont polarisés à Gnd. Les transistors 21, 22, 25 et 28 sont ménagés au dessus de caissons à dopage de type N, et au dessus de plan de masse à dopage de type P. Ces caissons à dopage de type N sont polarisés à Vdd. Ainsi, tous les plans de masse sont ménagés sur des caissons présentant un dopage de type opposé. Avec les polarisations présentées, les diodes formées aux jonctions entre plans de masse et caissons sont systématiquement polarisées en inverse, évitant ainsi tout court-circuit. Une tranchée d'isolation 192 sépare la rangée de transistors nMOS de la rangée de transistors pMOS.

Avec les polarisations et dopages mentionnés, les transistors 21, 22, 26 et 27 sont du type LVT, les transistors 25 et 28 sont du type RVT et les transistors 23 et 24 sont du type HVT. La configuration illustrée à la figure 8 correspond ainsi à une cointégration de transistors présentant différents niveaux de tension de seuil.

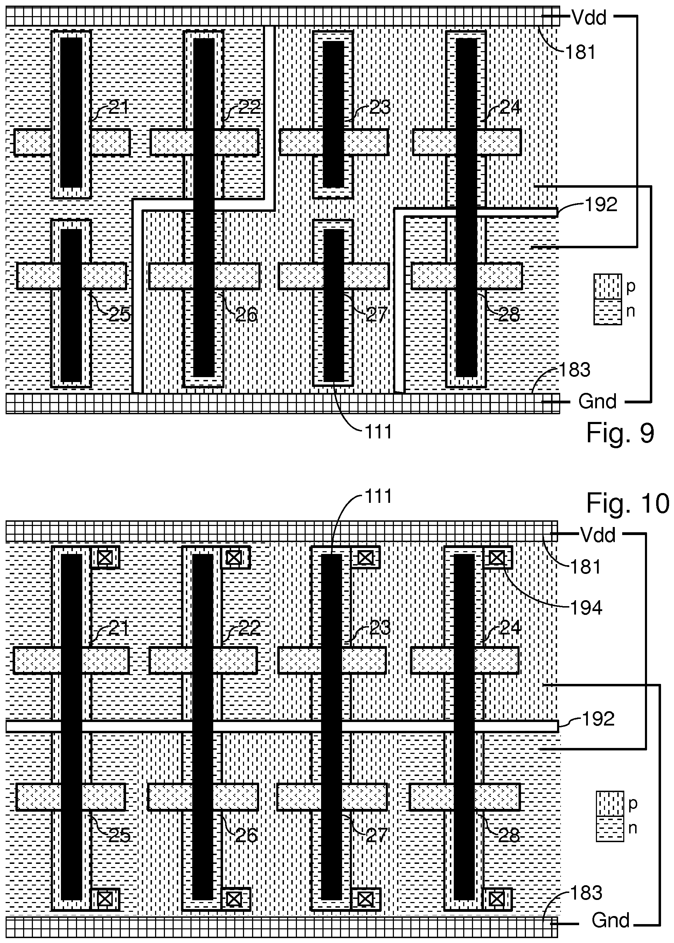

La figure 9 est une vue de dessus illustrant un deuxième exemple de cointégration de transistors présentant différentes tensions de seuil. Le circuit intégré comprend une rangée de transistors nMOS 21 à 24 et une rangée de transistors pMOS 25 à 28.

Les transistors 23, 24, 26 et 27 sont ménagés au dessus de caissons à dopage de type P, et au dessus de plans de masse à dopage de type N. Ces caissons à dopage de type P sont polarisés à Gnd. Les transistors 21, 22, 25 et 28 sont ménagés au dessus de caissons à dopage de type N, et au dessus de plans de masse à dopage de type P. Ces caissons à dopage de type N sont polarisés à Vdd. Ainsi, tous les plans de masse sont ménagés sur des caissons présentant un dopage de type opposé. Avec les polarisations présentées, les diodes formées aux jonctions entre plans de masse et caissons sont systématiquement polarisées en inverse, évitant ainsi tout court-circuit. Les tranchées d'isolation 192 permettent ici d'éviter un contact entre des caissons et des plans de masse présentant un même type de dopage.

La figure 10 est une vue de dessus illustrant un troisième exemple de cointégration de transistors présentant différentes tensions de seuil. Ces transistors correspondent au premier mode de réalisation de l'invention, les différents plans de masse étant ici polarisés par l'intermédiaire de contacts 194.

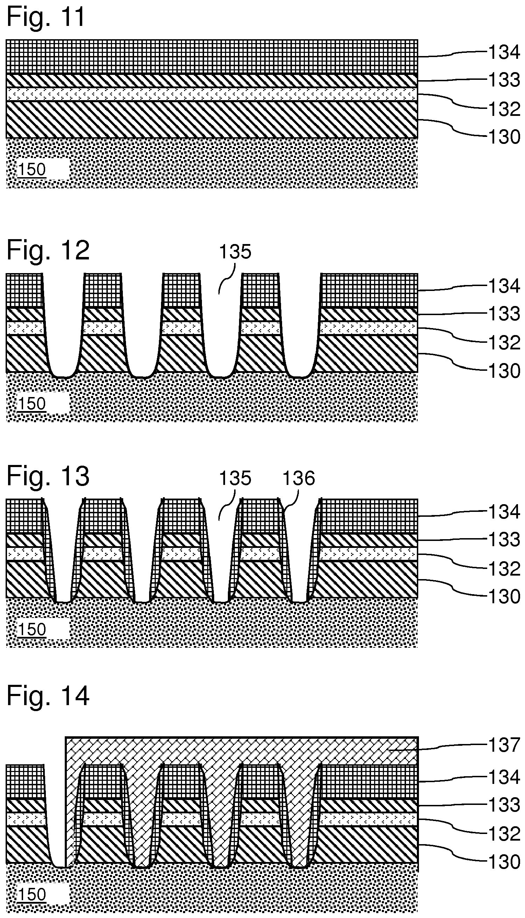

Les figures 11 à 22 sont des vues en coupe illustrant différentes étapes d'un exemple de procédé de fabrication d'un circuit intégré selon l'invention.

Comme illustré à la figure 11, une couche de silicium 132 extrêmement mince est déposée sur la couche d'isolant enterré 130, une couche tampon d'oxyde de silicium 133 est déposée sur la couche 132, et une couche de nitrure de silicium 134 est déposée sur la couche 133.

À la figure 12, les zones actives ont été définies par lithographie et gravure. Des gorges 135 sont ainsi formées jusqu'au substrat de silicium 150. Idéalement, la gravure est réalisée seulement jusqu'à l'interface entre le substrat 150 et la couche 130. Cependant, les gorges 135 peuvent avantageusement s'étendre dans le substrat de silicium 150 à une profondeur comprise entre zéro et 40 nm.

À la figure 13, on a réalisé des espaceurs 136 à l'intérieur des gorges 135, par dépôt d'un film de nitrure de silicium. Le nitrure de silicium des espaceurs 136 pourra être déposé avec l'équipement distribué sous la référence commerciale iRAD par la société Tokyo Electron Limited pour pouvoir présenter une sélectivité de gravure par rapport à la couche de nitrure de silicium 134. Les espaceurs 136 devront ainsi être gravés plus vite que la couche 134 lors d'une attaque chimique avec du HF glycol. Les espaceurs 136 peuvent par exemple être formés avec une épaisseur comprise entre 5 et 20 nm. Pour une gorge 135 dont la largeur est inférieure à deux fois l'épaisseur d'un espaceurs, la gorge 135 sera intégralement remplie par le nitrure de silicium. Avantageusement, l'épaisseur d'un espaceur 136 sera au moins du double de l'épaisseur de l'oxyde de grille.

À la figure 14, on a procédé au masquage d'une partie du circuit et à une gravure isotrope (par exemple avec un mélange HFEG ou H₃PO₄ avec un pH de solution >3) des espaceurs 136 dans les zones non masquées. Cette étape permet de cointégrer une zone comprenant des transistors selon l'invention sous le masque de résine 137, et une autre zone présentant des transistors selon l'état de la technique. On peut également envisager de s'affranchir d'une gravure avec résine en utilisant une fine couche d'oxyde comme masque dur, puis graver cette fine couche en BOE (pour Buffered Oxide Etch en langue anglaise) avec un pH >3, pour ensuite jouer le rôle de résine sans limitation de valeur de pH.

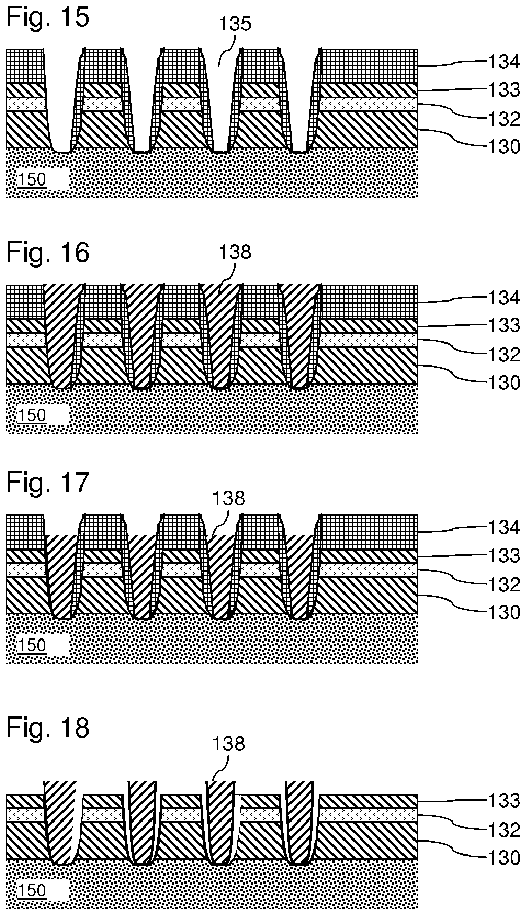

À la figure 15, on a procédé au retrait du masque de gravure 137, pour découvrir les espaceurs 136.

À la figure 16, on a procédé au remplissage des gorges 135 par de l'oxyde de silicium 138 et à une planarisation mécanochimique. Ces étapes sont bien connues de l'homme du métier pour la réalisation de tranchées d'isolation de type STI.

À la figure 17, on a procédé à une gravure chimique de l'oxyde de silicium 138 jusqu'à une profondeur souhaitée.

À la figure 18, on a procédé au retrait des espaceurs 136 et de la couche de nitrure de silicium 134, par exemple par une attaque à l'acide orthophosphorique H₃PO₄.

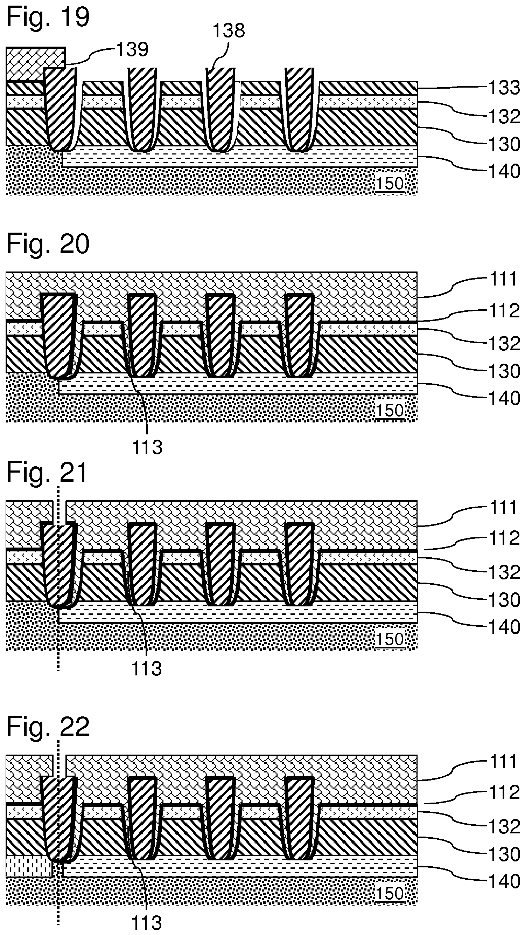

À la figure 19, on a procédé au dépôt d'un masque 139 de gravure, ce masque 139 découvrant la zone destinée à recevoir les transistors selon l'invention. Un plan de masse 140 est implanté dans le substrat 150, dans la zone découverte par le masque 139. On peut noter une implantation plus profonde du plan de masse 140 dans les zones au dessus des espaceurs 136 retirés auparavant. Cette différence d'implantation est relativement limitée lorsque l'épaisseur des espaceurs 136 est comprise entre 5 et 20 nm.

À la figure 20, on a retiré la couche tampon d'oxyde de silicium 133. Un film d'oxyde de grille 112 est déposé jusqu'en contact avec le plan de masse 140 (ce qui correspond à la première variante du premier mode de réalisation, l'oxyde de grille 112 assurant une séparation entre plan de masse 140 et grille 111). La grille métallique 111 est déposée sur l'oxyde de grille 112. La grille métallique 111 s'étend ainsi en profondeur sous forme de portions latérales saillantes 113 dans la zone précédemment occupée par les espaceurs 136. La grille métallique 111 recouvre ainsi des faces latérales de portions de la couche 130. Des canaux sont ainsi formés dans la couche de silicium 132.

À la figure 21, on a gravé la grille 111 pour former une séparation (matérialisée par le trait en pointillés) entre une grille pour un transistor selon l'état de la technique, et un transistor selon l'invention, présentant en particulier une multiplicité de canaux.

Du fait des remplissages en oxyde de silicium 138 entre les portions saillantes 114 de la grille, le volume des portions latérales 113 recouvrant les faces latérales de la couche isolante 130 est relativement limité.

Selon le procédé de fabrication décrit ci-dessus, le remplissage d'oxyde de silicium 138 peut être utilisé comme tranchée d'isolation entre des transistors selon l'invention et des transistors selon l'état de la technique, comme illustré à la figure 21. Des transistors selon l'invention peuvent bien entendu également être réalisés sans ménager de remplissages 138 d'oxyde de silicium entre deux portions latérales 113 d'une grille 111.

La figure 22 illustre une variante du circuit intégré au même stade du processus de fabrication qu'à la figure 21. Dans cette variante, le transistor placé à gauche du trait en pointillé est également réalisé selon l'état de la technique mais comporte un plan de masse à dopage de type P.

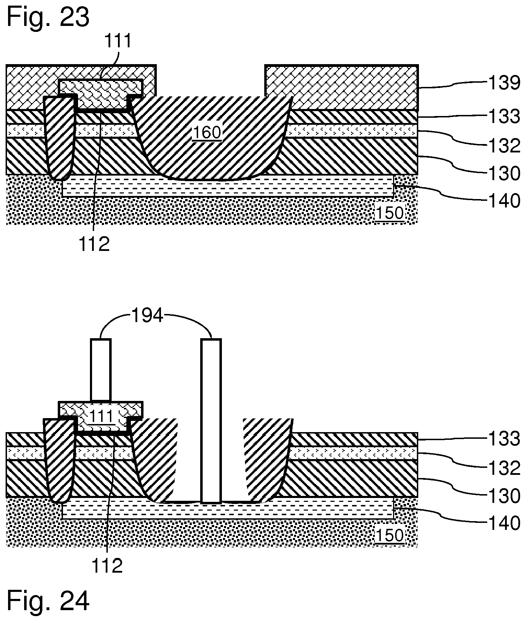

Les figures 23 et 24 illustrent des vues en coupe d'un circuit intégré d'une configuration selon la figure 10, durant deux étapes de son procédé de fabrication. La grille 111 est formée sur la couche d'oxyde de silicium 112, au dessus du canal d'un transistor. Un plot d'oxyde de silicium 160 de type STI est également formé au dessus du plan de masse 140 du transistor. Comme illustré à la figure 23, un masque de gravure 139 recouvre le circuit intégré, en découvrant la partie médiane du plot d'oxyde de silicium 160.

A la figure 24, on a gravé la partie médiane du plot 160 et on a retiré le masque de gravure 139. Des contacts métalliques 194 sont ici formés. Un contact 194 est en contact électrique avec la grille 111, et un contact 194 est en contact électrique avec le plan de masse 140.

## Revendications

1. Circuit intégré (1), comprenant :
- un substrat de silicium (150) ;
- un plan de masse (140) de silicium dopé disposé au-dessus du substrat ;
- une couche d'isolant enterré (130) disposée au-dessus du plan de masse ;
- une couche de silicium (100) disposée au-dessus de la couche d'isolant enterré et séparée du plan de masse par l'intermédiaire de la couche d'isolant enterré ;
- un transistor FDSOI dont le canal (161) est adapté à être formé dans la couche de silicium, dont la source et le drain sont disposés dans et/ou sur la couche de silicium (100), et dont la grille (111) recouvre la face supérieure (162) du canal et comporte au moins une portion latérale (113) recouvrant une face latérale (163) du canal et disposée au dessus du plan de masse, la distance entre ladite portion latérale (113) et le plan de masse étant inférieure ou égale à 3nm et au moins 5 fois inférieure à l'épaisseur de la couche d'isolant enterré (130) entre le plan de masse et la couche de silicium, le plan de masse (140) étant séparé de la grille (111) par la couche d'isolant enterré (130), et dans lequel le rapport entre la largeur du canal (161) et l'épaisseur du canal est compris entre 0,75 et 2,5.

2. Circuit intégré selon la revendication 1, dans lequel le plan de masse (140) est adapté à être en contact électrique avec la grille (111).

3. Circuit intégré selon l'une quelconque des revendications précédentes, dans lequel la portion latérale (113) de la grille (111) s'étend dans l'épaisseur de la couche d'isolant enterré (130).

4. Circuit intégré selon l'une quelconque des revendications précédentes, dans lequel le plan de masse (140) s'étend dans l'épaisseur de la couche d'isolant enterré (130) au dessous de la portion latérale de la grille.

5. Circuit intégré selon l'une quelconque des revendications précédentes, dans lequel ledit transistor est adapté pour comprendre un autre canal (164) s'étendant entre la source et le drain, ladite grille recouvrant la face supérieure de l'autre canal (164) et comportant une autre portion latérale recouvrant une face latérale de l'autre canal et disposée au dessus du plan de masse, la distance entre cette autre portion latérale et le plan de masse étant inférieure à l'épaisseur de la couche d'isolant enterré entre le plan de masse et la couche de silicium.

6. Procédé de fabrication d'un circuit intégré, comprenant les étapes de :
- fourniture d'un élément comprenant un substrat de silicium (150), un plan de masse de silicium dopé (140) disposé au-dessus du substrat, une couche d'isolant enterré (130) disposée au-dessus du plan de masse, une couche de silicium (100) disposée au-dessus de la couche d'isolant enterré et séparée du plan de masse par l'intermédiaire de la couche d'isolant enterré,
- formation du canal (161) d'un transistor FDSOI dans la couche de silicium, formation de la source et du drain du transistor FDSOI dans et sur la couche de silicium (100) ;
- formation d'une grille (111) du transistor FDSOI recouvrant la face supérieure (162) du canal et comportant au moins une portion latérale (113) recouvrant une face latérale (163) du canal et disposée au dessus du plan de masse, le plan de masse (140) étant séparé de la grille (111) par la couche d'isolant enterré (130) et la distance entre ladite portion latérale (113) et le plan de masse étant inférieure ou égale à 3nm et au moins 5 fois inférieure à l'épaisseur de la couche d'isolant enterré (130) entre le plan de masse et la couche de silicium, et le rapport entre la largeur du canal (161) et l'épaisseur du canal étant compris entre 0,75 et 2,5.

7. Procédé de fabrication selon la revendication 6, dans lequel la formation de la grille (111) comprend la formation d'un contact électrique entre la grille et le plan de masse (140).

8. Procédé de fabrication selon l'une quelconque des revendications 6 à 7, dans lequel la portion latérale (113) de la grille formée s'étend dans l'épaisseur de la couche d'isolant enterré.

9. Procédé de fabrication selon l'une quelconque des revendications 6 à 8, comprenant une étape d'épitaxie pour former une partie du plan de masse (140) s'étendant dans l'épaisseur de la couche d'isolant enterré (130) au-dessous de la portion latérale (113) de la grille.

## Patentansprüche

1. Integrierte Schaltung (1), umfassend:
- ein Silicium-Substrat (150);
- eine Masseebene (140) aus dotiertem Silicium, die über dem Substrat angeordnet ist;
- eine vergrabene Isolierschicht (130), die über der Masseebene angeordnet ist;
- eine Silicium-Schicht (100), die über der vergrabenen Isolierschicht angeordnet ist und von der Masseebene durch die vergrabene Isolierschicht getrennt ist;
- einen FDSOI Transistor, dessen Kanal (161) geeignet ist, in der Silicium-Schicht gebildet zu werden, dessen Source und Drain in und/oder auf der Silicium-Schicht (100) angeordnet sind, und dessen Gateelektrode (111) die obere Fläche (162) des Kanals bedeckt und mindestens einen lateralen Abschnitt (113) umfasst, der eine laterale Fläche (163) des Kanals bedeckt und über der Masseebene angeordnet ist, wobei die Distanz zwischen dem lateralen Abschnitt (113) und der Masseebene kleiner oder gleich 3 nm ist und mindestens 5-mal kleiner ist als die Dicke der vergrabenen Isolierschicht (130) zwischen der Masseebene und der Silicium-Schicht, wobei die Masseebene (140) von der Gateelektrode (111) durch die vergrabene Isolierschicht (130) getrennt ist, und wobei das Verhältnis zwischen der Breite des Kanals (161) und der Dicke des Kanals zwischen 0,75 und 2,5 beträgt.

2. Integrierte Schaltung nach Anspruch 1, wobei die Masseebene (140) geeignet ist, mit der Gateelektrode (111) in elektrischem Kontakt zu stehen.

3. Integrierte Schaltung nach einem der vorhergehenden Ansprüche, wobei sich der laterale Abschnitt (113) der Gateelektrode (111) in die Dicke der vergrabenen Isolierschicht (130) erstreckt.

4. Integrierte Schaltung nach einem der vorhergehenden Ansprüche, wobei sich die Masseebene (140) in die Dicke der vergrabenen Isolierschicht (130) unter dem lateralen Abschnitt der Gateelektrode erstreckt.

5. Integrierte Schaltung nach einem der vorhergehenden Ansprüche, wobei der Transistor geeignet ist, einen anderen Kanal (164) zu umfassen, der sich zwischen der Source und dem Drain erstreckt, wobei die Gateelektrode die obere Fläche des anderen Kanals (164) bedeckt und einen anderen lateralen Abschnitt umfasst, der eine laterale Fläche des anderen Kanals bedeckt und über der Masseebene angeordnet ist, wobei die Distanz zwischen diesem anderen lateralen Abschnitt und der Masseebene kleiner ist als die Dicke der vergrabenen Isolierschicht zwischen der Masseebene und der Silicium-Schicht.

6. Verfahren zur Herstellung einer integrierten Schaltung, umfassend die Schritte:
- Bereitstellen eines Elements, umfassend ein Silicium-Substrat (150), eine Masseebene (140) aus dotiertem Silicium, die über dem Substrat angeordnet ist, eine vergrabene Isolierschicht (130), die über der Masseebene angeordnet ist, eine Silicium-Schicht (100), die über der vergrabenen Isolierschicht angeordnet ist und von der Masseebene durch die vergrabene Isolierschicht getrennt wird,
- Bilden des Kanals (161) eines FDSOI Transistors in der Silicium-Schicht, Bilden der Source und des Drains des FDSOI Transistors in und auf der Silicium-Schicht (100);
- Bilden einer Gateelektrode (111) des FDSOI Transistors, welche die obere Fläche (162) des Kanals bedeckt und mindestens einen lateralen Abschnitt (113) umfasst, der eine laterale Fläche (163) des Kanals bedeckt und über der Masseebene angeordnet ist, wobei die Masseebene (140) von der Gateelektrode (111) durch die vergrabene Isolierschicht (130) getrennt wird, und wobei die Distanz zwischen dem lateralen Abschnitt (113) und der Masseebene kleiner oder gleich 3 nm ist und mindestens 5-mal kleiner ist als die Dicke der vergrabenen Isolierschicht (130) zwischen der Masseebene und der Silicium-Schicht, und wobei das Verhältnis zwischen der Breite des Kanals (161) und der Dicke des Kanals zwischen 0,75 und 2,5 beträgt.

7. Herstellungsverfahren nach Anspruch 6, wobei die Bildung der Gateelektrode (111) die Bildung eines elektrischen Kontakts zwischen der Gateelektrode und der Masseebene (140) umfasst.

8. Herstellungsverfahren nach einem der Ansprüche 6 bis 7, wobei sich der laterale Abschnitt (113) der gebildeten Gateelektrode in die Dicke der vergrabenen Isolierschicht erstreckt.

9. Herstellungsverfahren nach einem der Ansprüche 6 bis 8, umfassend einen Epitaxieschritt zur Bildung eines Teils der Masseebene (140), der sich in die Dicke der vergrabenen Isolierschicht (130) unter dem lateralen Abschnitt (113) der Gateelektrode erstreckt.

## Claims

1. Integrated circuit (1), comprising:
- a silicon substrate (150);
- an earth plane (140) of doped silicon disposed above the substrate;
- a buried insulator layer (130) disposed above the earth plane;
- a silicon layer (100) disposed above the buried insulator layer and separated from the earth plane by way of the buried insulator layer;
- an FDSOI transistor whose channel (161) is adapted for being formed in the silicon layer, whose source and drain are disposed in and/or on the silicon layer (100), and whose gate (111) covers the upper face (162) of the channel and comprises at least one lateral portion (113) covering a lateral face (163) of the channel and disposed above the earth plane, the distance between the said lateral portion (113) and the earth plane being less than or equal to 3 nm and at least 5 times less than the thickness of the buried insulator layer (130) between the earth plane and the silicon layer, the earth plane (140) being separated from the gate (111) by the buried insulator layer (130), and in which the ratio of the width of the channel (161) to the thickness of the channel lies between 0.75 and 2.5.

2. Integrated circuit according to Claim 1, in which the earth plane (140) is adapted for being in electrical contact with the gate (111).

3. Integrated circuit according to either of the preceding claims, in which the lateral portion (113) of the gate (111) extends in the thickness of the buried insulator layer (130).

4. Integrated circuit according to any one of the preceding claims, in which the earth plane (140) extends in the thickness of the buried insulator layer (130) below the lateral portion of the gate.

5. Integrated circuit according to any one of the preceding claims, in which the said transistor is adapted for comprising another channel (164) extending between the source and the drain, the said gate covering the upper face of the other channel (164) and comprising another lateral portion covering a lateral face of the other channel and disposed above the earth plane, the distance between this other lateral portion and the earth plane being less than the thickness of the buried insulator layer between the earth plane and the silicon layer.

6. Method of fabrication of an integrated circuit, comprising the steps of:
- provision of an element comprising a silicon substrate (150), an earth plane of doped silicon (140) disposed above the substrate, a buried insulator layer (130) disposed above the earth plane, a silicon layer (100) disposed above the buried insulator layer and separated from the earth plane by way of the buried insulator layer,
- formation of the channel (161) of an FDSOI transistor in the silicon layer, formation of the source and of the drain of the FDSOI transistor in and on the silicon layer (100);
- formation of a gate (111) of the FDSOI transistor covering the upper face (162) of the channel and comprising at least one lateral portion (113) covering a lateral face (163) of the channel and disposed above the earth plane, the earth plane (140) being separated from the gate (111) by the buried insulator layer (130) and the distance between the said lateral portion (113) and the earth plane being less than or equal to 3 nm and at least 5 times less than the thickness of the buried insulator layer (130) between the earth plane and the silicon layer, and the ratio of the width of the channel (161) to the thickness of the channel lying between 0.75 and 2.5.

7. Fabrication method according to Claim 6, in which the formation of the gate (111) comprises the formation of an electrical contact between the gate and the earth plane (140).

8. Fabrication method according to either one of Claims 6 and 7, in which the lateral portion (113) of the gate formed extends in the thickness of the buried insulator layer.

9. Fabrication method according to any one of Claims 6 to 8, comprising a step of epitaxy so as to form a part of the earth plane (140) extending in the thickness of the buried insulator layer (130) below the lateral portion (113) of the gate.
